# EUROPÄISCHE PATENTSCHRIFT

(11) **EP 1 759 412 B1**
(45) Veröffentlichungstag und Bekanntmachung des Hinweises auf die Patenterteilung: **30.11.2011**
(21) Anmeldenummer: 05769420.0
(22) Anmeldetag: 27.06.2005
(51) Int. Cl.: H01L 23/10, B60C 23/02

(54) **ELEKTRISCHE BAUGRUPPE MIT EINER SCHUTZHÜLLE**
ELECTRICAL SUBASSEMBLY COMPRISING A PROTECTIVE SHEATHING
MODULE ELECTRIQUE POURVU D'UNE ENVELOPPE PROTECTRICE

(30) Priorität: 25.06.2004 DE 102004030916
(43) Veröffentlichungstag der Anmeldung: 07.03.2007
(73) Patentinhaber: Conti Temic microelectronic GmbH, 90411 Nürnberg (DE)
(72) Erfinder: BABUTZKA, Wilfried, 73265 Dettingen (DE); HUBER, Dietmar, 85072 Eichstätt (DE); FOERG, Franz, 73342 Bad Ditzenbach (DE); SCHILLINGER, Jakob, 85080 Gaimersheim (DE)
(86) Internationale Anmeldenummer: PCT/DE2005/001161
(87) Internationale Veröffentlichungsnummer: WO 2006/000212

(56) Entgegenhaltungen:
- WO-A-2005/002887
- US-A- 3 749 601
- US-A- 5 971 046
- US-B1- 6 326 680
- PATENT ABSTRACTS OF JAPAN Bd. 015, Nr. 098 (E-1042), 8. März 1991 (1991-03-08) & JP 02 306609 A (NEC CORP), 20. Dezember 1990 (1990-12-20)

## Beschreibung

Die vorliegende Erfindung betrifft elektrische Baugruppen, insbesondere elektrische Baugruppen in Kraftfahrzeugen und deren Teilen, einschließlich deren Reifen.

Es ist bekannt, elektrische Baugruppen bzw. Funktionseinheiten zum Zwecke des Schutzes vor Umwelteinflüssen und/oder der mechanischen Befestigung mit einer äußeren Schutzhülle, insbesondere einer Kunststoffummantelung, zu versehen. Die Baugruppen umfassen dabei einen Leitungsträger, wie beispielsweise Leadframe, Leiterplatte, Hybrid, MID, Premold oder Carrier, und mindestens eine Komponente, bei der es sich beispielsweise um einen Widerstand, eine Induktivität, eine Kapazität, eine Diode, eine Zener-Diode, einen Transistor, ein PTC bzw. NTC, ein IC oder einen Sensor handeln kann, welche über eine geeignete Verbindungstechnik, wie beispielsweise Löten, Leitkleben, Schweißen, Crimpen, Leitpressen oder Klemmen, miteinander verbunden sind.

Die für die obige Schutzfunktion geeigneten Kunststoffe, wie Thermoplaste, Duroplaste, Verguss oder ähnliche, weisen als Umschließungsmaterial einen wesentlich unterschiedlichen Ausdehnungskoeffizienten im Vergleich zum Leitungsträger und/oder der Komponente auf, so dass bei Temperaturwechselbeanspruchungen mechanische Kräfte auf die Komponente, auf den Leitungsträger und auf die elektrischen bzw. mechanischen Verbindungsstellen zwischen Komponente und Leitungsträger hervorgerufen werden. Es entstehen hierbei gleichzeitig unterschiedliche Kräfte in unterschiedlichen Richtungen, wie beispielsweise Zug-, Druck-, Scher-, Biege- und/oder Torsionskräfte. Diese Wechselkräfte können eine Schädigung der elektrischen Verbindung hervorrufen, was von einer Erhöhung des Übergangswiderstandes bis hin zu einer Unterbrechung der Verbindung zur Komponente oder zu einer anderen Stelle des elektrischen Bauteils führen kann.

Aus der japanischen Patentanmeldung JP 02 306609 A ist eine elektrische Baugruppe mit einer äußeren Schutzhülle und zumindest einer elektrischen Komponente bekannt, wobei zwischen der elektrischen Komponente und der äußeren Schutzhülle zumindest an einem Teilbereich der Baugruppe eine innere Umhüllung vorgesehen ist, welche eine höhere Viskosität bzw. Elastizität als die äußere Schutzhülle aufweist.

Das Patent US 5,971,046 zeigt einen Reifen und eine darin angeordnete elektrische Baugruppe, wobei Reifen und Baugruppe über einen Flicken mittels Vulkanisierung verbunden sind.

Die Aufgabe der Erfindung besteht darin, durch geeignete Maßnahmen die mechanische Belastung der elektrischen Baugruppe und insbesondere der Verbindungsstellen zu reduzieren. Ferner soll ein geeignetes Verfahren zur Herstellung der elektrischen Baugruppen angegeben werden.

Diese Aufgabe wird bei einer elektrischen Baugruppe mit einer äußeren Schutzhülle erfindungsgemäß durch die Merkmale von Anspruch 1 gelöst. Die Baugruppe oder zumindest relevante Teilbereiche bzw. Komponenten dieser werden vollständig oder selektiv, insbesondere an den Verbindungsstellen, mit einer inneren Umhüllung versehen, welche eine höhere Viskosität bzw. Elastizität als die äußere Schutzhülle aufweist.

Hierdurch wird vermieden, dass die äußere Schutzhülle direkten mechanischen Kontakt mit den Komponenten der Baugruppe hat und somit die aus den unterschiedlichen Ausdehnungskoeffizienten herrührenden mechanischen Kräfte direkt auf die Komponenten bzw. die elektrische Verbindungsstellen einwirken können. Vielmehr weicht das im Vergleich zur äußeren Schutzhülle viskosere bzw. elastischere Material der inneren Umhüllung, welche sich räumlich zwischen der Komponente und der äußeren Schutzhülle befindet, aus und verhindert somit einen kraftschlüssigen Kontakt.

Dabei ist wenigstens eine Komponente über wenigstens einen Anschlussdraht mit einem Leitungsträger verbunden, wobei an dem Anschlussdraht vorzugsweise eine Sicke oder eine Schleife ausgebildet ist, die innerhalb der inneren Umhüllung vorgesehen ist. An dieser Stelle kann sich der Anschlussdraht ausdehnen bzw. zusammenziehen, ohne dass es zu einer Beschädigung kommt.

Als Material der inneren Umhüllung ist insbesondere ein weiches Silicon oder Polyurethan (PU) vorgesehen. Das Umhüllungsmaterial muss auf jeden Fall so gewählt werden, dass keine Vorschädigung der Komponenten bzw. des Materials selbst beim Umhüllungsprozess entsteht.

In der nachfolgenden Beschreibung werden die Merkmale und Einzelheiten der Erfindung in Zusammenhang mit den beigefügten Zeichnungen anhand von Ausführungsbeispielen näher erläutert. Dabei sind in einzelnen Varianten beschriebene Merkmale und Zusammenhänge grundsätzlich auf alle Ausführungsbeispiele übertragbar. In den Zeichnungen zeigen:
- Fig. 1: eine schematische Ansicht einer elektrischen Baugruppe mit einer äußeren Schutzhülle und einer erfindungsgemäßen inneren Umhüllung und
- Fig. 2: eine schematische Ansicht eines anderen Ausführungsbeispiels einer erfindungsgemäßen Baugruppe.

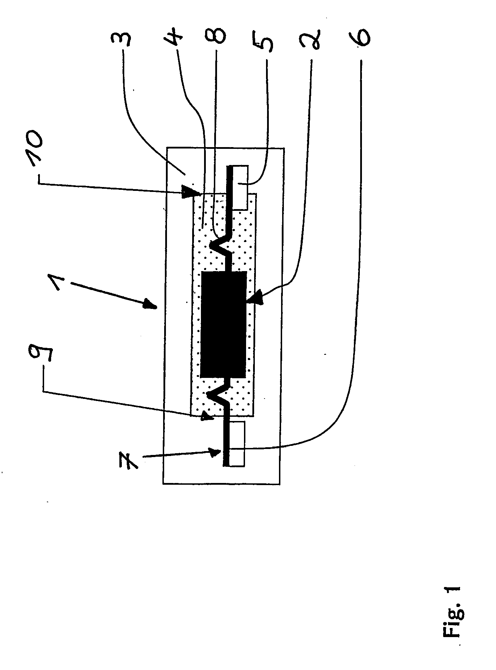

In Fig. 1 ist schematisch eine elektrische Baugruppe 1 mit einer äußeren Schutzhülle 3 dargestellt. Innerhalb der Schutzhülle 3 sind üblicherweise zumindest eine elektrische Komponente 2, ein Leitungsträger 5, eine Verbindungsstelle 6 vom Leitungsträger 5 zur Komponente 2 und ein Anschlussdraht 7 angeordnet. Bei der elektrische Komponente 2 kann es sich beispielsweise um einen Widerstand, eine Induktivität, eine Kapazität, eine Diode, eine Zener-Diode, ein Transistor, ein PTC bzw. NTC, ein IC oder einen Sensor handeln. Als Leitungsträger 5 bzw. Verdrahtungsträger kann insbesondere ein Leadframe, eine Leiterplatte, ein Hybrid, ein MID, ein Carrier oder ein Premold vorgesehen sein.

Die elektrischen Baugruppe 1 weist weiterhin eine innere Umhüllung 4 auf, wobei die Baugruppe 1 oder zumindest relevante Teilbereiche bzw. Komponenten 2 dieser vollständig oder selektiv mit der inneren Umhüllung 4 versehen sind, die erfindungsgemäß eine höhere Viskosität bzw. Elastizität als die äußere Schutzhülle 4 aufweist.

Hierdurch wird mit Vorteil vermieden, dass die äußere Schutzhülle 4 direkten mechanischen Kontakt mit den Komponenten 2 der Baugruppe 1 hat und somit die aus unterschiedlichen Ausdehnungskoeffizienten herrührenden mechanischen Kräfte direkt auf die Komponenten 2 bzw. die elektrische Verbindungsstellen 6 einwirken können. Vielmehr weicht das im Vergleich zur äußeren Schutzhülle 3 viskosere bzw. elastischere Material der inneren Umhüllung 4, welche sich räumlich zwischen der Komponente 2 und der äußeren Schutzhülle 3 befindet, aus und verhindert somit einen kraftschlüssigen Kontakt.

An der in Fig. 1 links dargestellten Stelle 9 sind der Leitungsträger 5 bzw. die Verbindungsstelle 6 nicht mit der inneren Umhüllung 4 versehen. In der erfindungsgemäßen Ausbildung an der Stelle 10, die in Fig. 1 rechts dargestellt ist, geschieht dies nur teilweise.

Üblicherweise ist wenigstens eine Komponente 2 über wenigstens einen Anschlussdraht 7 mit dem Leitungsträger 5 verbunden. An dem Anschlussdraht 7 ist in einer Weiterbildung der Erfindung vorzugsweise eine Sicke 8 oder eine Schleife (nicht dargestellt) ausgebildet, die innerhalb der inneren Umhüllung 4 vorgesehen ist. An dieser Stelle kann sich der Anschlussdraht 7 ausdehnen bzw. zusammenziehen, ohne dass es zu einer Beschädigung kommt.

Als Material der inneren Umhüllung 4 ist insbesondere ein weiches Silicon oder Polyurethan (PU) vorgesehen. Das Umhüllungsmaterial muss auf jeden Fall so gewählt werden, dass keine Vorschädigung der Komponenten 2 bzw. des Materials selbst beim Umhtillungsprozess entsteht. Als Material für die äußere Schutzhülle 3 können beispielsweise Thermoplast, Duroplast oder auch harter Verguss verwendet werden.

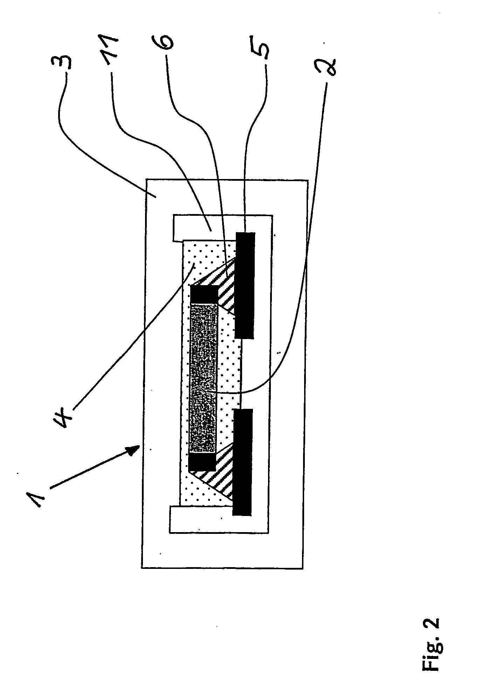

In Fig. 2 ist in schematischer Ansicht ein weiteres Ausführungsbeispiel der vorliegenden Erfindung dargestellt. Die Verbindungsstelle 6 ist hier als Lötverbindung zwischen der Komponente 2 und dem Leitungsträger 5 ausgebildet. Im Unterschied zu Fig. 1 und bevorzugt sind dabei die Verbindungsstellen 6 innerhalb der inneren Umhüllung 4 bzw. zwischen der inneren Umhüllung 4 und dem Leitungsträger 5 vorgesehen.

Zusätzlich kann ein Zwischenverdrahtungsträger 11 vorgesehen sein, der insbesondere als Premold ausgebildet sein kann. Die erfindungsgemäße innere Umhüllung 4 ist dann am bzw. im Premold 11 angeordnet.

Bei einem Verfahren zur Herstellung der elektrischen Baugruppe 1 wird zumindest an vorgegebenen Teilbereichen der Baugruppe 1 zunächst eine innere Umhüllung 4 aufgebracht und nachfolgend die Baugruppe 1 insgesamt mit einer äußeren Schutzhülle 3 versehen.

Für das Aufbringen der äußeren Schutzhülle 3 bieten sich als Fertigungsverfahren das Umspritzen, Overmolden, Transfermolden oder Vergießen an. Die innere Umhüllung 4 wird vorzugsweise vor oder nach dem Herstellen der elektrischen Verbindung zwischen den Komponenten 2 oder eines Zwischenverdrahtungsträgers 11 zu dem Leitungsträger 5 aufgebracht.

### Bezugszeichenliste

- 1: Elektrische Baugruppe
- 2: Komponente
- 3: äußere Schutzhülle
- 4: innere Umhüllung
- 5: Leitungsträger
- 6: Verbindungsstelle
- 7: Anschlussdraht
- 8: Sicke
- 9: Variante mit Leitungsträger nicht im Umhüllung
- 10: Variante mit Leitungsträger teilweise im Umhüllung
- 11: Zwischenträger

## Patentansprüche

1. Elektrische Baugruppe (1) mit einer äußeren Schutzhülle (3) und zumindest einer elektrischen Komponente (2), wobei zwischen der elektrischen Komponente (2) und der äußeren Schutzhülle (3) zumindest an einem Teilbereich der Baugruppe (1) eine innere Umhüllung (4) vorgesehen ist, welche eine höhere Viskosität bzw. Elastizität als die äußere Schutzhülle (3) aufweist, **dadurch gekennzeichnet, dass** die elektrische Komponente (2) an einer Verbindungsstelle (6) mit einem Leitungsträger (5) verbunden und die innere Umhüllung (4) zumindest im Bereich der Verbindungsstelle (6) vorgesehen ist.

2. Elektrische Baugruppe (1) nach Anspruch 1, dadurch gekenntzeichnet, dass die Komponente (2) über wenigstens einen Anschlussdraht (7) mit dem Leitungsträger (5) verbunden ist und an dem Anschlussdraht eine Sicke (8) ausgebildet ist, die innerhalb der inneren Umhüllung (4) vorgesehen ist.

3. Elektrische Baugruppe (1) nach einem der vorangehenden Ansprüche, **dadurch gekennzeichnet, dass** als Material der inneren Umhüllung (4) ein weiches Silicon oder Polyurethan (PU) vorgesehen ist.

## Claims

1. Electrical assembly (1) having an outer protective sheathing (3) and at least one electrical component (2), wherein an inner covering (4) is provided between the electrical component (2) and the outer protective sheathing (3) at least on a section of the assembly (1), said inner covering (4) having a higher viscosity or elasticity than the outer protective sheathing (3), **characterized in that** the electrical component (2) is connected, at a junction (6), to a line carrier (5) and the inner covering (4) is provided at least in the region of the junction (6).

2. Electrical assembly (1) according to claim 1, **characterized in that** the component (2) is connected to the line carrier (5) via at least one lead wire (7) and a bead (8) is formed on the lead wire, said bead (8) being provided within the inner covering (4).

3. Electrical assembly (1) according to any one of the preceding claims, **characterized in that** a soft silicone or polyurethane (PU) is provided as a material for the inner covering (4).

## Revendications

1. Sous-ensemble électrique (1), avec une enveloppe de protection extérieure (3) et au moins un composant (2) électrique, une gaine intérieure (4) étant prévue entre le composant (2) électrique et l'enveloppe de protection extérieure (3) au moins sur une zone partielle du sous-ensemble électrique (1), cette gaine présentant une viscosité ou une élasticité plus élevée que l'enveloppe de protection extérieure (3), **caractérisé en ce que** le composant (2) électrique est connecté à un porte-conducteur (5) au niveau d'un emplacement de connexion (6), et **en ce que** la gaine intérieure (4) est prévue au moins dans la zone de l'emplacement de connexion (6).

2. Sous-ensemble électrique (1) selon la revendication 1, **caractérisé en ce que** le composant (2) est connecté au porte-conducteur (5) par le biais d'au moins un fil de connexion (7), et **en ce qu'**au moins une moulure (8) est constituée au niveau du fil de connexion et est prévue à l'intérieur de la gaine intérieure (4).

3. Sous-ensemble électrique (1) selon une des revendications précédentes, **caractérisé en ce que**, comme matériau de la gaine intérieure (4), il est prévu un polyuréthane (PU) ou silicone tendre.
